(19) Europäisches Patentamt
European Patent Office
Office européen des brevets

(11) EP 4 737 414 A1

# (12) EUROPEAN PATENT APPLICATION

(43) Date of publication:
**06.05.2026 Bulletin 2026/19**

(21) Application number: **25210324.7**

(22) Date of filing: **22.10.2025**

(51) International Patent Classification (IPC):
***C03C 14/00*** *(2006.01)* ***C03B 19/06*** *(2006.01)*

(52) Cooperative Patent Classification (CPC):
**C03C 14/004; C03B 19/06; C03B 19/066;**
C03C 2214/16

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **31.10.2024 EP 24210179**
**29.08.2025 EP 25199061**

(71) Applicant: **Heraeus Quarzglas GmbH & Co. KG**
**63450 Hanau (DE)**

(72) Inventors:
- **Dr. Götzendorfer, Andreas**
**63801 Kleinostheim (DE)**
- **Tscholitsch, Nadine**
**63801 Kleinostheim (DE)**
- **Hammerschmidt, Jörg**
**63801 Kleinostheim (DE)**
- **Jenek, Torsten**
**63801 Kleinostheim (DE)**
- **Dr. Wessely, Frank**
**63801 Kleinostheim (DE)**

(74) Representative: **Heraeus IP**
**Heraeus Business Solutions GmbH**
**Intellectual Property**
**Heraeusstraße 12-14**
**63450 Hanau (DE)**

## (54) OPAQUE QUARTZ GLASS HAVING HIGH ABSORPTION IN THE INFRARED RANGE

(57) The invention relates to an opaque quartz glass having high absorption in the near infrared range and to a method for producing same. The present invention also relates to the use of the opaque quartz glass according to the invention or the opaque quartz glass resulting from the method according to the invention in process chambers in which semiconductor wafers are processed.

Figure 5

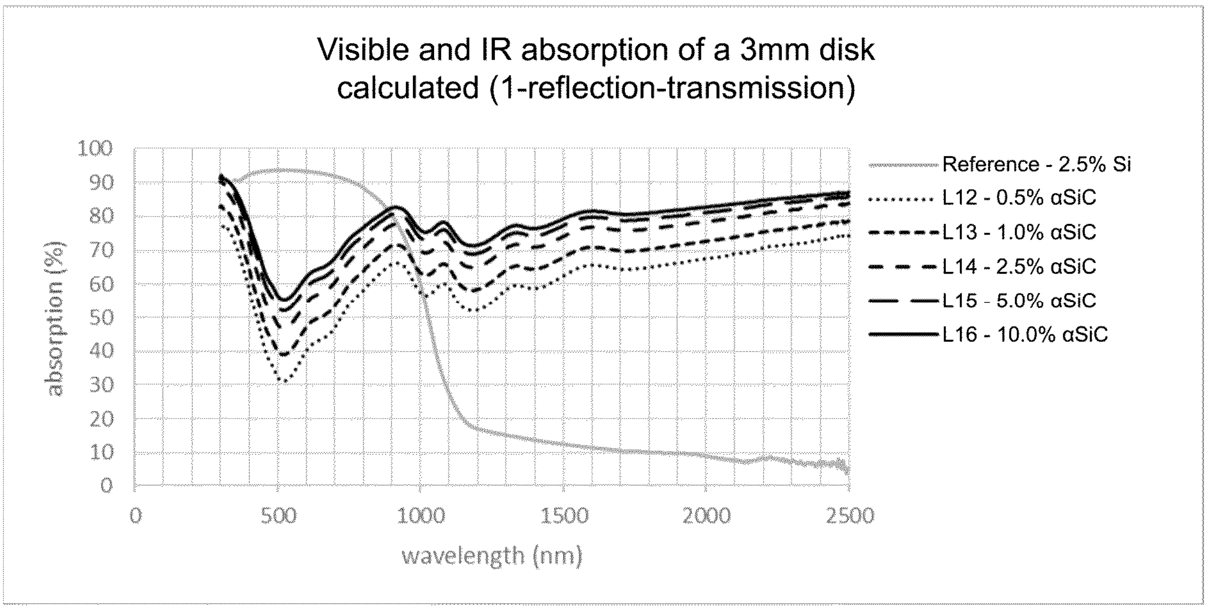


EP 4 737 414 A1

## Description

The invention relates to an opaque quartz glass having high absorption in the infrared wavelength range from 1 to 10 μm, and to a method for producing same. The present invention also relates to the use of the opaque quartz glass according to the invention or the opaque quartz glass resulting from the method according to the invention in process chambers in which semiconductor wafers are processed.

A variety of devices are used in the production of semiconductor components and optical displays, such as reactors, apparatus, support plates, bell jars, crucibles, protective shields or simpler components such as tubes, rods, plates, flanges, rings or blocks. They must meet high requirements in terms of purity, chemical and thermal stability and mechanical strength. They can be made of stainless steel, for example, but are increasingly being made of quartz glass. The reason for this is that the silicon dioxide material, at high purity, is inert to conventional semiconductor materials. Quartz glass is also characterized by high chemical stability with respect to numerous process media and also by high thermal shock resistance.

Some components in process chambers where semiconductor wafers are processed at high temperatures are heated by means of radiation from lamps. In order to ensure fast and efficient heat transfer, the material used for this purpose must have high absorption, in particular in the near infrared, i.e., in the range from 1 to 3 μm. Since the components must also have low thermal mass in order to enable rapid thermal cycles of heating and cooling, high absorption must be achieved even when the components are very thin or have a small wall thickness. Since process control is difficult when the absorption of the material is heavily dependent on the temperature, it is advantageous for the absorption to be dependent on the temperature to the smallest possible extent. These (infrared) optical properties should be combined, as far as possible, with the proven properties of high-purity quartz glass for applications in process chambers for wafer processing.

**In** addition, components made of other materials, high-purity silicon carbide (e.g. CVD-SiC) and high-purity Si, are also used. However, the production and processing of these materials are significantly more complex and expensive than for quartz glass.

Corresponding quartz glass materials are described, for example, in EP 3 068 739 A. The material described is a composite material comprising a matrix which is made of quartz glass in which regions of a silicon-containing phase are embedded. Although the composite material has a high absorption at visible wavelengths and in the near infrared up to 1 μm, the absorption drops significantly at room temperature. It is only at higher temperatures that the absorption increases for a wavelength range of greater than 1 μm, and reaches a constant value from approximately 1000°C. However, at lower temperatures, infrared absorption is highly temperature dependent, which makes process control difficult and therefore disadvantageous.

Another composite material proposed for applications in process chambers for wafer processing is known from US 2001/025001 A. The composite material consists of quartz glass and a second phase made of silicon, silicon carbide, silicon nitride, titanium nitride or titanium carbide. The aim is to provide a material that is less vulnerable to cracking during mechanical processing than quartz glass and that releases fewer particles. Due to the production method, the composite material has an open porosity of less than 15% or less than 5%. Open-pored materials are very difficult to clean, in particular with liquids or acids. During mechanical processing, impurities can penetrate into open pore channels. It is virtually impossible to remove these impurities without leaving residues. Furthermore, optical properties of the resulting material are not described and - as long as silicon carbide is the second phase in the composite - the resulting material from US 2001/025001 A contains carbon. This results from the production method used: silicon carbide as a starting material always contains carbon as an impurity, and this is not removed in the described production method of vacuum sintering under pressure.

JP 2006/027930 A relates to a black quartz glass, the black color being caused by the incorporation of graphite particles. The quartz glass is produced by sintering from a mixture of amorphous quartz glass powder (soot) and graphite powder having defined grain size distributions. The carbon particles used make up 0.05 to 2 wt.% of the $SiO_2$ weight, the diameters are 0.07 to 0.5 μm or 0.05 to 1 μm. Inter alia, ground quartz glass is used as the $SiO_2$ powder, which quartz glass is produced by flame hydrolysis in a hydrogen/oxygen flame. The resulting material is sintered at 1100 to 1500°C. At temperatures that are too high, a decrease in the density of the quartz glass is observed, due to the formation of bubbles. The resulting quartz glass contains elemental carbon, which is disadvantageous for certain applications.

JPH05170477 A relates to a black quartz glass and a cell for optical analyses using this glass. The quartz glass is doped with 0.05 to 0.3 wt.% SiC (based on the C concentration). The devitrification stability is increased by doping with nitrogen (10 - 5000 ppm), fluorine (10 - 5000 ppm) and chlorine (10 - 1000 ppm). The transmission at a layer thickness of 1 mm is at most 1% in the wavelength range between 200 and 25,000 nm. The resulting quartz glass is obtained by sintering in the absence of oxygen at temperatures greater than or equal to 1700°C. At these temperatures $SiO_2$ is reduced by C to form SiC and CO. This is followed by a further reaction between SiC and $SiO_2$ to form SiO and CO. This produces gaseous carbon oxides, which form bubbles in the resulting material. **In** order to compress the bubbles and keep them small, sintering is preferably carried out under pressure. The resulting material is a black color, which can be attributed to impurities and/or carbon. The particle size of the SiC particles used is in the range from 0.1 to 1 μm, which makes absorption in the near infrared ineffective.

US 5,674,792 relates to a method for producing opaque quartz glass material from a slip (slip casting method); the described material contains only $SiO_2$ particles and pores.

US 6,355,587 relates to the production of quartz glass products by means of special production methods and doping. The quartz glass products are produced by adding low amounts (0.005 to 0.01 wt.%) of silicon nitrite or silicon carbide, with SiC particles added to the slurry disintegrating during sintering at temperatures above 1400°C and releasing gas, such that a plurality of bubbles trapped in the glass form. The dense-sintered final product therefore no longer contains any SiC. The resulting products have a bubble density of approximately 80 to 120 bubbles/$mm^2$ with an average bubble size of ≤ 20 μm. Glass products of this kind block infrared radiation and are used, among other things, as heat shields.

JP H06 122533 describes a method for producing a composite material, in which $SiO_2$ is deposited as a micropowder by flame hydrolysis, then organochlorosilane from the gas phase is deposited at at least 700°C on the $SiO_2$ powder and likewise at at least 700°C is converted into SiC by a heat treatment under a hydrogen atmosphere. Finally, it is compressed at at least 1700°C in a non-oxidizing atmosphere. The resulting composite material has silicon carbide particles in a size of at most 20 nm, which means that absorption in the near infrared is low. In the described method, sintering or melting is carried out at at least 1700°C in a non-oxidizing atmosphere in order to compress the glass, although, as the publication itself states, quartz glass and silicon carbide react with one another to form a gas above 1400°C. On the other hand, the examples given in the publication suggest that free carbon is present in the material at heat treatments below 1700°C and no silicon carbide has been produced yet. Therefore, high temperatures of at least 1700°C are required so that carbon and $SiO_2$ can react to form silicon carbide. CO is however also certainly produced at these temperatures, resulting in a very bubbly material.

WO 2025/159866 A and US 2025/0236987 A both disclose a component comprising a body having a composition comprising a mixture of silicon carbide (SiC) particles suspended in crystalline quartz. The method for the preparation of the composition comprises a step of suspending the said silicone carbide particles in liquid quartz to form the composition. The product resulting from the preparation method is a transparent quartz with SiC particles, and therefore transparent for visible light in the visible wavelength range. The material described therein provides a variety of emissivities at different temperatures.

The disadvantage of these composite materials known from the prior art is that the absorption at wavelengths in the near infrared, i.e., from 1 to 3 μm, is low at room temperature and is also too heavily dependent on the temperature. Impurities, especially with metallic compounds, can increase absorption in this range, but are undesirable in materials for semiconductor applications. A proportion of elemental carbon, such as that found in $SiO_2$/SiC composite materials from US 2001/025001 A, is disadvantageous.

The object of the present invention is therefore to provide a composite material which has the highest possible absorption in the near infrared, i.e., from 1 to 3 μm, even at room temperature, and which also has absorption which has low dependency on temperature. These (infrared) optical properties should be combined with the proven properties of high-purity quartz glass for applications in process chambers for wafer processing. These required properties are selected, inter alia, from the group consisting of high purity, high temperature resistance, high thermal shock resistance, high chemical resistance, good electrical insulation, good mechanical strength, the possibility of residue-free cleaning, e.g., by ultrasonic cleaning and hydrofluoric acid (HF) cleaning, mechanical workability, low particle release in the process and, compared to high-purity ceramics, low production costs.

These objects are achieved in the context of the present invention by a composite material having a matrix which is made of quartz glass and in which regions of a silicon carbide-containing phase are embedded.

The object of the present invention is therefore a composite material having a matrix which is made of quartz glass and in which regions of a silicon carbide-containing phase are embedded.

According to the invention, it was found that a composite material having a matrix which is made of quartz glass and in which regions of a silicon carbide-containing phase are embedded has a high absorption in the near infrared, i.e., from 1 to 3 μm, even at room temperature, and also has absorption which has low dependency on temperature, and is therefore ideally suited for use in process chambers for wafer processing.

Compared to the composite material made of $SiO_2$ and silicon described in EP 3 068 739 A, the composite material according to the invention has significantly higher absorption in the infrared range at wavelengths of greater than or equal to 1 μm at temperatures below 1000°C. In addition, the absorption of the material in this wavelength range is far less temperature-dependent than the comparable composite material according to EP 3 068 739 A.

Compared to the composite material in US 2001/025001 A, the composite material according to the invention has substantially no carbon, which is preferred for its intended use.

The matrix of the composite material according to the invention is either opaque, translucent or transparent. In the matrix there are very finely distributed regions of a phase that contain silicon carbide (SiC) and are referred to herein as the silicon carbide-containing phase.

These regions affect the overall heat absorption of the composite material according to the invention. This is substantially due to the properties of the silicon carbide.

The composite material according to the invention has a high absorption in the near infrared, i.e., from 1 - 3 μm, and therefore the material can be heated efficiently and quickly even with small wall thicknesses.

The composite material according to the invention has an absorption of a 3 mm thick disk at 1500 nm of preferably greater than 40%, more preferably greater than 50%.

In addition, the composite material according to the invention has a small change in the absorptance (or emissivity) of a 3 mm disk in the NIR at a wavelength of 1.5 μm between room temperature (20°C) and 1000°C. The change in absorptance (or emissivity) is preferably less than 0.3, more preferably less than 0.2, particularly preferably less than 0.1. In this regard, the composite material according to the invention is distinguished from the material described in WO 2025/159866 A and US 2025/0236987 A mentioned above in which the material possesses a variety of emissivities at different temperatures.

The silicon carbide-containing phases are very finely and homogeneously distributed in the quartz glass matrix. Although they can lie directly on the surface of the composite material, a coating to protect against oxidation is not required. A coating would otherwise lead to additional undesirable reflections at the interface with the composite material.

The weight proportion of silicon carbide-containing phase, in each case based on the matrix made of quartz glass, in the composite material according to the invention, is preferably less than or equal to 10 wt.%, more preferably less than or equal to 9 wt.%, even more preferably less than or equal to 8 wt.%, even more preferably less than or equal to 7 wt.%, even more preferably less than or equal to 6 wt.%, even more preferably less than or equal to 5 wt.%.

A weight proportion of silicon carbide-containing phase, based on the matrix made of quartz glass, in the composite material according to the invention of less than 5 wt.% is desirable due to the low porosity desired according to the invention, which is described further below.

The weight proportion of silicon carbide-containing phase, in each case based on the matrix made of quartz glass, in the composite material according to the invention, is preferably greater than or equal to 0.1 wt.%, more preferably greater than or equal to 0.25 wt.%, even more preferably greater than or equal to 0.5 wt.%, even more preferably greater than or equal to 1 wt.%, even more preferably greater than or equal to 1.5 wt.%, even more preferably greater than or equal to 2 wt.%, even more preferably greater than or equal to 2.5 wt.%.

In the embodiment of the present invention, the weight proportion of silicon carbide-containing phase, in each case based on the matrix made of quartz glass, in the composite material according to the invention, is preferably 0.1 to 5 wt.%, more preferably 0.25 to 5 wt.%, even more preferably 0.5 to 5 wt.%, even more preferably 1 to 5 wt.%, even more preferably 1.5 to 5 wt.%, even more preferably 2 to 5 wt.%, even more preferably 2.5 to 5 wt.%.

The weight proportion of silicon carbide-containing phase, in each case based on the matrix made of quartz glass, in the composite material according to the invention, is preferably 0.25 to 10 wt.%, more preferably 0.5 to 9 wt.%, even more preferably 1 to 8 wt.%, even more preferably 1.5 to 7 wt.%, even more preferably 2 to 6 wt.%, even more preferably 2.5 to 5 wt.%.

The heat absorption of the composite material according to the invention is dependent on the proportion of the silicon carbide-containing phase. The greater the proportion of this phase, the higher the absorptance and the emissivity. The weight proportion of the silicon carbide-containing phase should therefore preferably be above the minimum amounts defined above. On the other hand, a high proportion by volume of the silicon carbide-containing phase may complicate the production of the composite material, and therefore the maximum amounts given above represent a suitable upper limit. The silicon carbide-containing phase is mainly responsible for the absorption in the infrared wavelength range from greater than 1 μm to 5 μm.

The matrix of the composite material according to the invention preferably consists of quartz glass with a hydroxyl group content of at most 30 ppm by weight. Hydroxyl groups cause a decrease in the viscosity of quartz glass. Hydroxyl groups are therefore unfavorable with regard to high dimensional stability under thermal stress, and therefore the above-mentioned maximum amount should preferably be observed.

The hydroxyl group content of transparent quartz glass is usually determined using infrared transmission measurement. However, this measurement method is not readily suitable for the heat-absorbing composite material. Therefore, the hydroxyl group content of the composite material is determined using emission measurements in the region of the absorption wavelength of the hydroxyl groups in quartz glass (at 2.72 μm), by comparison with a standard with known hydroxyl group content.

The matrix of the composite material according to the invention can consist of undoped or doped quartz glass. In the context of the invention, doped quartz glass can contain, in addition to $SiO_2$, other oxide, nitride or carbide constituents in a quantity of up to at most 1000 ppm.

The regions of a silicon carbide-containing phase are preferably formed from particulate silicon carbide. In this case, the d90 value of the particle size distribution of the silicon carbide particles is preferably less than 100 μm, more preferably less than 75 μm, even more preferably less than 50 μm.

Furthermore, the $d_{50}$ value of the particle size distribution of the silicon carbide particles is preferably greater than

0.1 μm, more preferably greater than 0.5 μm, even more preferably greater than 1 μm, even more preferably greater than 2 μm.

Furthermore, the $d_{50}$ value of the particle size distribution of the silicon carbide particles is preferably less than 100 μm, more preferably less than 75 μm, even more preferably less than 50 μm, even more preferably less than 25 μm.

This results in regions for the $d_{50}$ value of the particle size distribution of the silicon carbide particles preferably of from 0.1 to 100 μm, more preferably from 0.5 to 75 μm, even more preferably from 1 to 50 μm, even more preferably from 2 to 25 μm.

In the context of the present invention, the average size of the silicon carbide particles is particularly preferably adapted to the average particle size of the $SiO_2$ matrix particles, such that undesirable separation effects due to sedimentation do not occur during the production of the composite materials according to the invention.

The particle size distribution was measured by laser diffraction using the Mastersizer 3000 from Malvern.

The silicon carbide in the silicon carbide-containing phase can be present in the composite material according to the invention in any modification. In the context of the present invention, it is preferred if the silicon carbide in the composite material according to the invention is present as an α-SiC and/or as a β-SiC modification. It is particularly preferred if the silicon carbide in the composite material according to the invention is present as an α-SiC modification.

Due to the intended use of the composite material according to the invention, it is preferred if the composite material has high purity. Therefore, the maximum values of permissible impurities in the respective constituents of the composite material according to the invention are preferably subject to certain restrictions, which are described in more detail below.

Accordingly, it is preferred for the silicon carbide-containing phase to comprise metal impurities of preferably less than 50 ppm, more preferably less than 25 ppm, even more preferably less than 10 ppm, the metal impurities being determined by glow discharge spectroscopy.

It is further preferred if the matrix made of quartz glass comprises metal impurities of preferably less than 100 ppm, more preferably less than 50 ppm, even more preferably less than 25 ppm, the metal impurities being determined by optical emission spectroscopy with inductively coupled plasma.

It is further preferred if the composite material according to the invention comprises metal impurities of preferably less than 100 ppm, more preferably less than 50 ppm, even more preferably less than 25 ppm, the metal impurities being determined by optical emission spectroscopy with inductively coupled plasma.

Metal impurities include alkali metals, alkaline-earth metals, transition metals, and other metals as classified in the periodic table of the elements.

A low cristobalite content in the matrix of 1% or less ensures a low devitrification tendency and thus a low risk of crack formation during operation.

In the context of the present invention, iron and copper in particular should be avoided as metal impurities.

Furthermore, it is in particular preferred if the composite material according to the invention has a carbon content of less than 0.1 wt.%, more preferably less than 0.075 wt.%, even more preferably less than 0.05 wt.%, in each case based on the total weight of the composite material. In particular, the composite material according to the invention is free of carbon.

The carbon content here refers to the content of elemental carbon and does not include the amount of carbon in the silicon carbide-containing phase.

The low proportion of carbon in the composite material according to the invention is achieved by its production method described below. During its production, the composite material according to the invention is sintered at high temperatures under an atmosphere of air, i.e., in the presence of oxygen, resulting in the low carbon content.

Due to the intended use of the composite material according to the invention, it is preferred if the composite material has a low porosity.

It is therefore preferred if the composite material according to the invention has a porosity of less than 8%, more preferably less than 6%, even more preferably less than 5%, the porosity being defined as the pore volume based on the total volume of the composite material.

In particular, it is preferred if the composite material according to the invention has no open porosity.

Large pores in the composite material according to the invention can contribute to undesirable diffuse reflections. The low porosity of the composite material according to the invention limits this effect. In addition, the matrix preferably contains small pores having a maximum pore size of less than 50 μm. The pores form predominantly between sintered $SiO_2$ particles and generally have a non-circular shape.

The low porosity and small pore size achieved according to the invention of the composite material according to the invention also leads to further technical advantages, such as high strength, high etching resistance (e.g., during wet etching with HF (an acid that is often used to clean quartz glass components)) and low roughness of mechanically polished surfaces.

Due to the low porosity of the quartz glass matrix and the associated low diffuse reflection, visible light and infrared radiation can penetrate deep into the matrix and thus reach deeper absorption centers consisting of the silicon carbide-containing phase. This contributes to greater absorption.

Micrographs and dye penetration tests show that the composite material according to the invention has no open porosity. The residual porosity remaining after sintering is closed pores.

Due to this preferred porosity according to the invention, it is possible to clean the resulting composite materials according to the invention without leaving residues. Ultrasonic cleaning or cleaning with hydrofluoric acid (HF), for example, is suitable for this purpose.

The composite material according to the invention has a reflectance value of preferably 10 to 150, more preferably 20 to 100, even more preferably 25 to 90. In the context of the present invention, the reflectance value is measured using the Chroma Meter CR-410 colorimeter from Konica Minolta (Y value in the Yxy color space).

The composite material according to the invention has an L* value (perceptual lightness) in the L*a*b* color space of preferably 20 to 200, more preferably 30 to 150, even more preferably 40 to 100.

The composite material according to the invention has a hemispherical transmission of a 3 mm thick disk made of the composite material of less than 10%, more preferably less than 9%, more preferably less than 8%, more preferably less than 7%, more preferably less than 6%, more preferably less than 5%, more preferably less than 4%, more preferably less than 3%, more preferably less than 2%, more preferably less than 1%, even more preferably less than 0.6%, in the wavelength range from 400 to 2500 nm, making the composite material according to the invention particularly beneficial for the intended use described below. The transmission is determined using a spectrometer (grating spectrometer), an integrating sphere being used to integrate the reflected and transmitted radiation, making it possible to measure the hemispherical reflection and transmission. Unlike the present invention, the material described in WO 2025/159866 A and US 2025/0236987 A is transparent.

The composite material according to the invention has a hemispherical reflection of a 3 mm thick disk made of the composite material of preferably less than 60%, more preferably less than 50%, in each case at a wavelength of 1500 nm.

The composite material according to the invention has a change in the absorptance / emissivity of a 3 mm disk at a wavelength of 1.5 $\mu$m between room temperature (20°C) and 1000°C of less than 0.3, more preferably less than 0.2, particularly preferably less than 0.1.

The emissivity referred to here is "normal spectral emissivity". This value is determined based on a measurement principle known as "black-body boundary conditions" (BBC) and published in "DETERMINING THE TRANSMITTANCE AND EMITTANCE OF TRANSPARENT AND SEMITRANSPARENT MATERIALS AT ELEVATED TEMPERATURES"; J. Manara, M. Keller, D. Kraus, M. Arduini-Schuster; 5th European Thermal-Sciences Conference, Netherlands (2008). According to Kirchhoff's law of radiation, the normal spectral emissivity for any body is equal to the normal spectral absorptance, abbreviated here to absorption.

For room temperature, the absorption A is calculated from the measured hemispherical reflection R and the measured hemispherical transmission T using the following equation:

$$A = 1 - R - T.$$

The composite material according to the invention has a specific density of preferably at least 2.13 g/cm$^3$, more preferably of at least 2.14 g/cm$^3$, even more preferably at least 2.15 g/cm$^3$, the specific density being determined according to Archimedes.

Since the composite material according to the invention has no open porosity, a simple density measurement according to Archimedes' principle is possible. The porosity is determined using the density measurement, taking into account the specific composition of the composite material according to the invention and the specific densities of the quartz glass matrix and the silicon carbide-containing phase, and therefore the porosity defined above (proportion of the pore volume relative to the total volume) is calculated from the specific density and the proportions of the constituents used in the composite material according to the invention.

The composite material according to the invention differs from the composite material described in EP 3 068 739 A by the additional addition of silicon carbide particles. The composite material according to the invention has no open porosity and thus differs from the silicon composites described in US 2001/025001 A, which are still open-pored. In order to achieve the desired absorption, it is also not necessary to have such high proportions of silicon carbide as the materials described in US 2001/025001 A.

The differences in the material properties between the materials described in US 2001/025001 A and the composite material according to the invention are due to the different production methods. The composite material according to the invention is produced by means of slip casting, as described below, thereby achieving green bodies with a higher density than with the dry pressing described in US 2001/025001 A. As a result, high-density composites without open porosity are achieved by atmospheric sintering even at temperatures below 1400°C, whereas the dry-pressed Si composite materials from US 2001/025001 A are still open-pored despite hot pressing at 1400°C under high pressure (20 to 40 MPa). It is not possible to sinter the dry-pressed green bodies sufficiently under atmospheric conditions.

Compared to the $SiO_2$/Si composite described in EP 3 068 739 A, the composite material according to the invention has significantly higher absorption in the infrared range at wavelengths of greater than 1 μm at temperatures below 1000°C. In addition, the absorption of the material in this wavelength range is far less dependent on temperature.

The composite material according to the invention is sintered under normal atmospheric conditions, as described below. Under these sintering conditions, any plastics particles and organic compounds (e.g. abrasion from containers and tools, additives such as binders or filtration aids) still contained in the powder and the green body produced therefrom, and residues of elemental carbon due to common impurities in the silicon carbide, are burned by reaction with the oxygen contained in the air and thus removed. These reactions take place during the heating of the green body in a temperature range below 1000°C, in which the molded body is still open-pored and resulting gaseous compounds can easily escape.

The silicon carbide-containing composite materials described in US 2001/025001 A had to be sintered under vacuum and pressure in order to achieve closed porosity. Therefore, these composites still contain residual elemental carbon.

**In** order to achieve the desired absorption in the composite materials according to the invention, it is not necessary to have such high proportions of silicon carbide contents (greater than 5 wt.%) as the materials in US 2001/025001 A.

The present invention further relates to a method for producing a composite material, in particular for producing a composite material as described above.

The method according to the invention is characterized by the following method steps:

a. providing a mixture comprising amorphous quartz glass particles and a silicon carbide-containing powder as a suspension;

b. forming a shaped body by means of a slip casting method starting from the suspension produced in method step a. to obtain a green body;

c. drying the green body; and

d. sintering the dried green body resulting from method step c.

The specifics of the individual constituents described above, such as particle size, particle size distribution, purity, etc., also apply, mutatis mutandis, to the method according to the invention.

Method step a. is preferably carried out by mixing the silicon carbide-containing powder into an aqueous suspension consisting of quartz glass particles. In addition, additives known from ceramic process technology, such as dispersing aids, filtration aids, binders, etc., can be added in method step a.

The grain size distribution of the quartz glass particles in the suspension provided in method step a. has a d90 value of preferably less than 100 μm, more preferably less than 75 μm, even more preferably less than 50 μm, in each case determined by laser diffraction according to ISO 2019:13320.

The solids content in the aqueous suspension consisting of quartz glass particles provided in method step a. is preferably more than 50 wt.%, more preferably more than 65 wt.%, even more preferably more than 75 wt.%. Identical solids contents are also achieved for the resulting mixture of quartz glass particles and silicon carbide-containing powder.

The silicon carbide-containing powder can be mixed with the quartz glass powder before the suspension is produced. Dry mixing, for example, is suitable for this purpose.

However, it has proven particularly advantageous if the silicon carbide-containing powder is mixed into the liquid containing the amorphous quartz glass powder, as already mentioned.

**In** method step a. of the production method according to the invention, the silicon carbide-containing powder can preferably be mixed into the liquid containing quartz glass particles in a mixing system with an agitator or dissolver.

The silicon carbide-containing powder is mixed in before the liquid is removed. Homogeneous mixing is particularly easy to achieve in the suspension.

The solids content, particle size and particle size distribution of the quartz glass particles affect the contraction of the green body during subsequent drying. For example, contraction during drying can be reduced by using relatively coarse $SiO_2$ particles. In this context, established quartz glass powders are those in which the amorphous quartz glass particles have particle sizes in the range up to at most 200 μm, more preferably at most 100 μm, with quartz glass particles having particle sizes between 1 μm and 60 μm making up the largest proportion by volume of the quartz glass powder.

**In** method step b. of the production method according to the invention, the slip casting method is carried out such that the mixed suspension of the quartz glass particles and of the silicon carbide-containing powder is filled into molds, the molds containing porous components via which part of the water is removed from the suspension, thereby forming a dimensionally stable body.

**In** method step c., the green body is preferably removed from the mold and dried, with any residual water remaining in the green body evaporating.

The dried green body resulting from method step c. has a density preferably of greater than or equal to 1.60 g/cm$^3$, more preferably greater than or equal to 1.65 g/cm$^3$, even more preferably greater than or equal to 1.70 g/cm$^3$.

The slip casting method according to the invention leads to an intermediate state in the form of a green body. Both the slip casting method and the intermediate product of the green body allow for measures to adjust and modify properties that affect the final composite material.

Thus, processing the starting powders in the suspension facilitates their intimate mixing and the creation of a homogeneous distribution in the green body. The liquid also acts as a binder or activator between the solid components. The liquid can modify the surfaces of the powder particles and, in particular, lead to interactions between them, which can contribute to a more impermeable and more stable bond during the subsequent sintering.

The suspension may be based on an organic solvent, preferably alcohol-based or more preferably aqueous-based. The polar nature of the aqueous phase may be advantageous for the above-mentioned interactions of the quartz glass.

**In** the green body state, the composite composed of the quartz glass phase and the silicon carbide-containing phase is porous and can be modified via the gas phase, in particular by doping and reactive drying.

It should be taken into account that the molded body shrinks significantly during the final sintering in method step d. Typically, the linear shrinkage is approximately 10%. Therefore, the green body must be larger than the sintered molded body. The sintered molded body is then further mechanically processed in order to obtain the final component. The sintered molded body has a near-net shape.

This can be, for example, a solid body, a hollow body or a layer on a main body. The green body can be produced by casting the suspension into a mold. However, other processing methods for the suspension are also suitable, for instance layer-by-layer application by dipping, spraying, brushing, applying with a spatula, transferring, laying down, doctoring and the like.

The green body is dried and a largely anhydrous molded body is obtained. However, as an inevitable consequence of its production, the green body contains a large amount of hydroxyl groups. **It** is then generally sintered to form a gas-impermeable, mechanically resilient molded body.

The method according to the invention may preferably comprise a method step in which the dried green body resulting from method step c. is mechanically processed before the sintering in method step d.

The sintering temperature in method step d. must be selected such that the highest possible density of the sintered composite material is achieved. The parameters suitable for the sintering (sintering temperature, sintering time and atmosphere) can be determined by simple experiments. Examples of suitable method conditions are described below.

The method step d. of sintering is carried out at a temperature preferably of greater than or equal to 1300°C, more preferably greater than or equal to 1325°C, even more preferably greater than or equal to 1350°C. The material becomes compressed and the molded body shrinks, it being possible for the linear shrinkage to be approximately 10%.

The method step c. is carried out in particular at a temperature of less than 1600°C, more preferably less than 1500°C, even more preferably less than 1400°C.

The duration of method step d. depends on the temperature and the initial density of the green body. At 1390°C, 4 hours are generally sufficient for slip-cast green bodies to achieve completely closed porosity. At lower temperatures, the method step e. may take longer.

The method step d. of sintering is preferably carried out under atmospheric conditions, i.e., in air and under standard pressure.

After sintering, the green body made of quartz glass and silicon carbide particles results in a material that has a significantly lower hydroxide group content than material produced by sintering a green body consisting exclusively of $SiO_2$ particles.

During the sintering, water and hydroxyl groups present are consumed and converted into $SiO_2$. Due to the slip casting production technique, the content of hydroxyl groups in the sintered component is surprisingly low and is preferably less than 30 ppm by weight. This results in a relatively high viscosity of the composite material.

The method of the present invention is different compared with the preparation method described in WO 2025/159866 A and US 2025/0236987 A wherein the SiC particles are placed in liquid quartz. In contrast, the present invention places the SiC particles in an aqueous suspension of solid quartz glass particles at room temperature. After moulding using slip casting, a sintering at temperatures below the melting temperature of quartz occurs in the present invention so that there is no liquid quartz realized in the whole process of the invention.

As the present invention provides sintering under normal atmospheric conditions, the quartz glass matrix contains pores and is therefore opaque and not transparent as the material described in WO 2025/159866 A and US 2025/0236987 A.

The present invention also relates to the use of the composite material according to the invention for producing components of process chambers for wafer production and processing. The components according to the invention consist entirely or partially of the composite material according to the invention. If the component consists only partially of the composite material according to the invention, this material preferably forms at least part of the surface of the component. Due to its chemical composition, a coating made of the composite material according to the invention is particularly suitable for application to quartz glass, i.e., for the production of quartz glass/composite material composite parts. The component, or at least the surface of the component, has the optical and structural properties explained.

The component according to the invention thus has, at least in regions, a quartz glass matrix having a low pore content and an encapsulated silicon carbide-containing phase finely distributed therein. Even with thin layers having an extension of approximately 1 mm, the component according to the invention is opaque in the visible wavelength range, but otherwise largely has the chemical and mechanical properties typical of quartz glass.

In addition to being used for applications that require high heat absorption and uniform temperature distribution, the component is also suitable for applications in which high thermal and chemical stability and high resistance to corrosive gases and liquids are important. Such requirements often exist for components in semiconductor manufacturing, optics and chemical engineering.

The high emissivity of the composite material makes the component particularly suitable for use in the context of heat treatments in which a reproducible and homogeneous temperature distribution is important.

According to the invention, therefore, the use of the component is provided for components of process chambers in which semiconductor wafers are processed into chips. In particular, the components are used in systems in which high-temperature processes (e.g. CVD, ALD, epitaxy or annealing) are carried out.

Another intended use according to the invention is for components that are heated by means of radiation (lamp) and for components that are intended to block thermal radiation.

The component according to the invention is provided as a component of a process chamber for use in an oxidation or heat treatment process, in epitaxy or in chemical vapor deposition.

The component can, for example, take the form of a vessel, a bowl, a housing, a solid body, or a hollow body in an extended or curved form. In simple cases, the component is designed as a plate, ring, flange, dome, crucible, solid or hollow cylinder. The composite material can be in the form of a solid body or a layer.

<u>Exemplary embodiment:</u>

The samples 1 (L12), 2 (L13), 3 (L14), 4 (L15), 5 (L16), 6 (L20), 7 (L21), 8 (L22), 9 (L6), 10 (reference A), 11 (reference B) and 12 (reference C) were produced as follows:
An aqueous suspension of ground quartz glass particles was used as the starting material for the production of the laboratory samples. The solids content of the suspension was 78 wt.%, the D90 value of the particle size distribution was 45 μm.

SiC powder was added to the suspension using a laboratory stirrer according to the proportions given in Table 1 (values relate to the quantity of $SiO_2$).

The D10, D50 and D90 values of the particle size distributions of the SiC powder were as follows:

SiC powder 1:

$$D10 = 2.9\ \mu m,\ D50 = 5.4\ \mu m,\ D90 = 9.6\ \mu m$$

SiC powder 2:

$$D10 = 1.7\ \mu m,\ D50 = 8.2\ \mu m,\ D90 = 16.8\ \mu m$$

The particle sizes were measured by laser diffraction using the Mastersizer 3000 from Malvern.

Powder 1 consists mainly of α-SiC (Polytype 6H), whereas powder 2 is β-SiC (Polytype 3C). The crystal structure was determined using X-ray diffraction.

To produce the test specimens, the mixed suspension was cast into a cylindrical mold, the bottom of which consisted of porous material, through which part of the water was removed from the suspension until a dimensionally stable green body was formed.

After completion of the forming process, the green body was dried in a drying cabinet at 60°C to a residual moisture content of < 1%.

The dried green body was then sintered in an electrically heated furnace using the sintering parameters given in the table.

The optical measurements and the density measurement were carried out on a sample cut from the center of the sintered cylindrical molded body.

The color measurements were carried out on a cross-sectional area of the sintered molded body halved along its axis.

Table 1

| Sample | Proportion of Si | Proportion of SiC powder 1, α-type | Proportion of SiC powder 2, β-type | Sintering parameters (temperature, dwell time) | Density ($g/cm^3$), measured | Porosity, calculated | Reflectance Y in the Yxy color space | Perceptual Lightness L* in the L*a*b* color space | a* in the L*a*b* color space | b* in the L*a*b* color space |
|---|---|---|---|---|---|---|---|---|---|---|
| L12 | 0% | 0.5% | 0% | 1390°C, 5h | 2.147 | 2.61% | 53.9 | 78.4 | -6.90 | 4.51 |
| L13 | 0% | 1.0% | 0% | | 2.142 | 2.98% | 49.3 | 75.6 | -7.31 | 4.62 |
| L14 | 0% | 2.5% | 0% | | 2.154 | 2.91% | 42.1 | 70.9 | -8.02 | 5.36 |
| L15 | 0% | 5.0% | 0% | | 2.156 | 3.52% | 38.9 | 68.7 | -7.89 | 5.43 |
| L16 | 0% | 10.0% | 0% | | 2.181 | 3.78% | 36.4 | 66.8 | -7.70 | 5.67 |
| L20 | 0% | 0% | 0.5% | | 2.159 | 2.06% | 57.1 | 80.3 | -5.97 | 17.73 |
| L21 | 0% | 0% | 2.5% | | 2.153 | 2.93% | 48.1 | 74.9 | -6.45 | 20.16 |
| L22 | 0% | 0% | 10.0% | | 2.178 | 3.89% | 41.8 | 70.7 | -5.49 | 19.59 |
| L6 | 0% | 2.5% | 0% | 1390°C, 10h | 2.105 | 5.08% | 38.6 | 68.5 | -8.40 | 5.76 |
| Reference A | - | - | - | 1390°C, 5h | 2.184 | 0.77% | | | | |
| Reference B | 2.5% | - | - | 1390°C, 5h | 2.193 | 0.50% | | | | |
| Reference C | 2.5% | - | - | 1390°C, 8h | 2.198 | 0.28% | | | | |

Fig. 1 shows the hemispherical reflection in the visible range and the hemispherical reflection in the IR range of 3 mm-thick composite materials that do not comprise a silicon carbide-containing phase and that comprise silicon carbide-containing phases with different quantities of α-silicon carbide.

Fig. 2 shows the hemispherical reflection in the visible range and the hemispherical reflection in the IR range of 3 mm-thick composite materials that do not comprise a silicon carbide-containing phase and that comprise silicon carbide-containing phases with different quantities of β-silicon carbide.

Fig. 3 shows the hemispherical transmission in the visible range and the hemispherical reflection in the IR range of 3 mm-thick composite materials that do not comprise a silicon carbide-containing phase and that comprise silicon carbide-containing phases with different quantities of α-silicon carbide.

Fig. 4 shows the hemispherical transmission in the visible range and the hemispherical reflection in the IR range of 3 mm-thick composite materials that do not comprise a silicon carbide-containing phase and that comprise silicon carbide-containing phases with different quantities of β-silicon carbide.

Fig. 5 shows the calculated hemispherical absorption in the visible range and the calculated hemispherical absorption in the IR range of 3 mm-thick composite materials that do not comprise a silicon carbide-containing phase and that comprise silicon carbide-containing phases with different quantities of α-silicon carbide.

Fig. 6 shows the calculated hemispherical absorption in the visible range and the calculated hemispherical absorption in the IR range of 3 mm-thick composite materials that do not comprise a silicon carbide-containing phase and that comprise silicon carbide-containing phases with different quantities of β-silicon carbide.

Fig. 1 and 2 show that the composite materials according to the invention exhibit a decrease in hemispherical reflection at wavelengths above approximately 1000 nm, compared to the composite material according to EP 3 068 739 A, which was produced without a silicon carbide-containing phase.

Fig. 3 and 4 show that the composite materials according to the invention exhibit exceptionally low permeability to IR radiation which is considerably lower than the IR permeability of the composite material according to EP 3 068 739 A, which was produced without a silicon carbide-containing phase.

Fig. 5 and 6 show that the composite materials according to the invention exhibit high absorption at wavelengths above approximately 1000 nm, compared to the composite material according to EP 3 068 739 A, which was produced without a silicon carbide-containing phase.

Fig. 7 shows the emissivity at elevated temperatures for a composite material according to the invention having 2.5 wt.% α-silicon carbide at different temperatures of 500°C, 750°C and 1000°C.

It is clear from Fig. 7 that the emissivity of the composite material according to the invention in the wavelength range from 1-5 μm increases with increasing temperature up to more than 0.8 at 1000°C. The temperature-dependent fluctuation in the emissivity is however very low.

The absorptance at high temperatures of the composite materials according to the invention is determined by measuring the emissivity. The temperature behavior of the absorptance of a sample having 2.5 wt.% silicon carbide in the near infrared at a wavelength of 1.5 μm is shown in Fig. 10 and in the following Table 2.

Fig. 8 shows an SEM image of a cross-sectional area of a composite material according to the invention, having 2.5 wt.% silicon carbide, which was sintered for 5 hours at 1390°C. P denotes a pore and SiC denotes SiC particles embedded in the quartz glass matrix.

Fig. 9 shows an SEM image of a cross-sectional area of a composite material according to the invention, having 2.5 wt.% silicon carbide, which was sintered for 10 hours at 1390°C. P denotes a pore and SiC denotes SiC particles embedded in the quartz glass matrix.

Fig. 8 and 9 show that the composite materials according to the invention have a low porosity according to the invention. Longer sintering increases the porosity.

Table 2

| | Sample L15, 5.0% αSiC, 3mm disk |
|---|---|
| Temperature | Emissivity / absorptance at 1.5 μm |
| 20°C | 0.77 |
| 500°C | 0.80 |
| 750°C | 0.82 |
| 1000°C | 0.84 |
| Increase from 20 to 1000°C | 0.07 |

## Claims

1. A composite material comprising a matrix which is made of quartz glass and into which regions of a silicon carbide-containing phase are embedded.

2. The composite material according to claim 1, **characterized in that** the composite material has an absorption of a 3 mm thick disk at 1500 nm of greater than 40%, more preferably greater than 50%.

3. The composite material according to claim 1 or 2, **characterized in that** the composite material has a hemispherical reflection of a 3 mm thick disk at 1500 nm of less than 60%, more preferably less than 50%.

4. The composite material according to any of claims 1 to 3, **characterized in that** the composite material has a transmission of a 3 mm thick disk of less than 10%, more preferably less than 1%, even more preferably less than 0.6%, in the wavelength range from 0.4 to 2.5 μm.

5. The composite material according to any of claims 1 to 4, **characterized in that** the composite material has a change in the absorption capacity / emissivity of a 3 mm disk at a wavelength of 1.5 μm between room temperature (20°C) and 1000°C of less than 0.3, more preferably less than 0.2, particularly preferably less than 0.1.

6. The composite material according to any of claims 1 to 5, **characterized in that** the weight proportion of the silicon carbide-containing phase, in each case based on the matrix made of quartz glass, is 0.25 to 10 wt.%, more preferably 0.5 to 9 wt.%, even more preferably 1 to 8 wt.%, even more preferably 1.5 to 7 wt.%, even more preferably 2 to 6 wt.%, even more preferably 2.5 to 5 wt.%.

7. The composite material according to any of claims 1 to 6, **characterized in that** the $d_{50}$ value of the particle size distribution of the silicon carbide particles is 0.1 to 100 μm, more preferably 0.5 to 75 μm, even more preferably 1 to 50 μm, even more preferably 2 to 25 μm.

8. The composite material according to any of claims 1 to 7, **characterized in that** the composite material has metal impurities of less than 100 ppm, more preferably less than 50 ppm, even more preferably less than 25 ppm, the metal impurities being determined by optical emission spectroscopy with inductively coupled plasma.

9. The composite material according to any of claims 1 to 8, **characterized in that** the composite material has a porosity of less than 8%, more preferably less than 6%, even more preferably less than 5%, the porosity being defined as the pore volume based on the total volume of the composite material.

10. The composite material according to any of claims 1 to 9, **characterized in that** the composite material has a carbon content of less than 0.1 wt.%, more preferably less than 0.075 wt.%, even more preferably less than 0.05 wt.%, in each case based on the total weight of the composite material.

11. The composite material according to any of claims 1 to 10, **characterized in that** the composite material is free of carbon.

12. A method for producing the composite material according to any of claims 1 to 11, **characterized by** the following method steps:

    a. providing a mixture comprising amorphous quartz glass particles and a silicon carbide-containing powder as a suspension;
    b. forming a shaped body by means of a slip casting method starting from the suspension produced in method step a. to obtain a green body;
    c. drying the green body; and
    d. sintering the dried green body resulting from method step c.

13. The method according to claim 12, **characterized in that** the grain size distribution of the quartz glass particles in the suspension has a d90 value of less than 100 μm, more preferably less than 75 μm, even more preferably less than 50 μm, in each case determined by laser diffraction according to ISO 2019:13320.

14. The method according to claim 12 or 13, **characterized in that** the solids content in the aqueous suspension consisting of quartz glass particles is more than 50 wt.%, more preferably more than 65 wt.%, even more preferably more than 75 wt.%.

**15.** A use of a composite material according to any of claims 1 to 11 for producing a part for components of process chambers in which semiconductor wafers are processed into chips, for systems in which high-temperature processes are carried out, for components which are heated by means of radiation and for components which block thermal radiation.

Figure 1

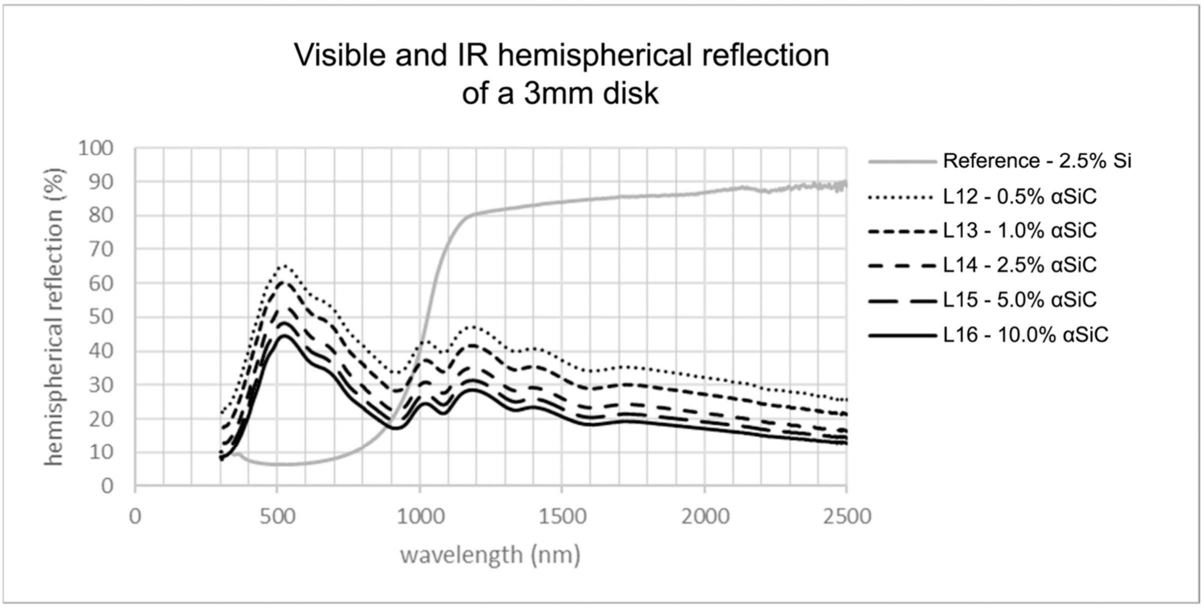


Figure 2

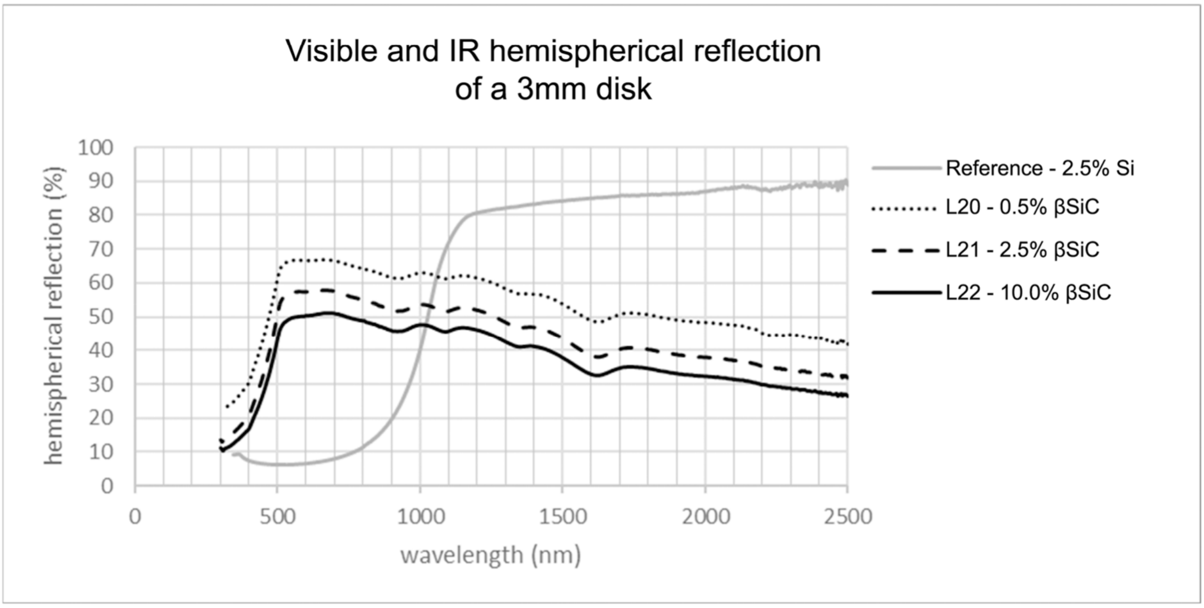

Figure 3

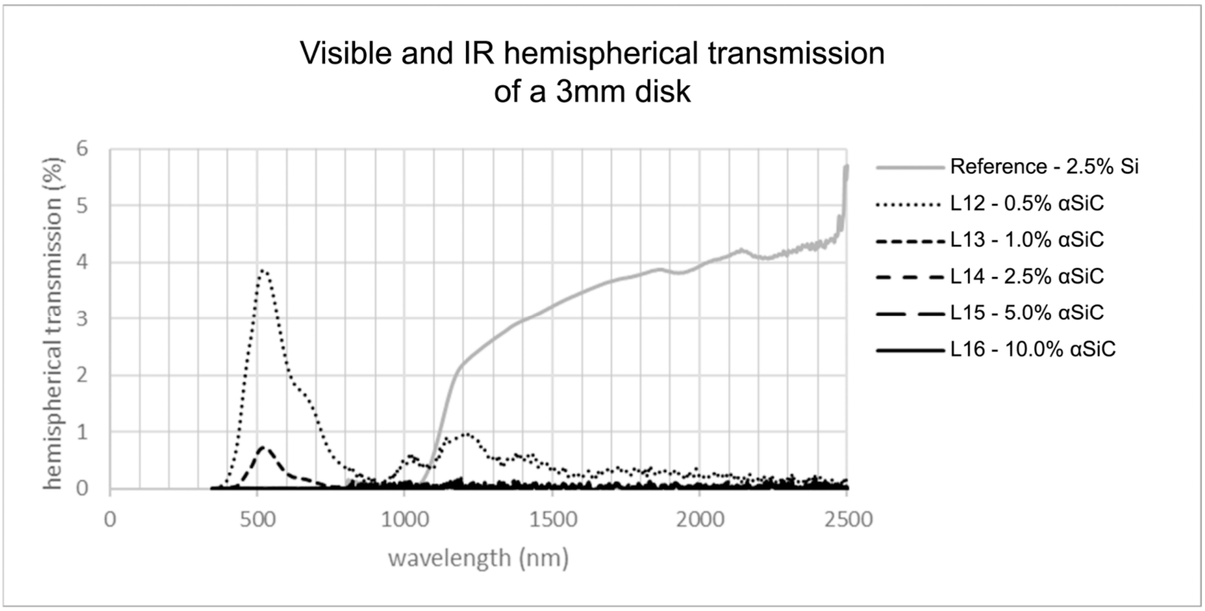


Figure 4

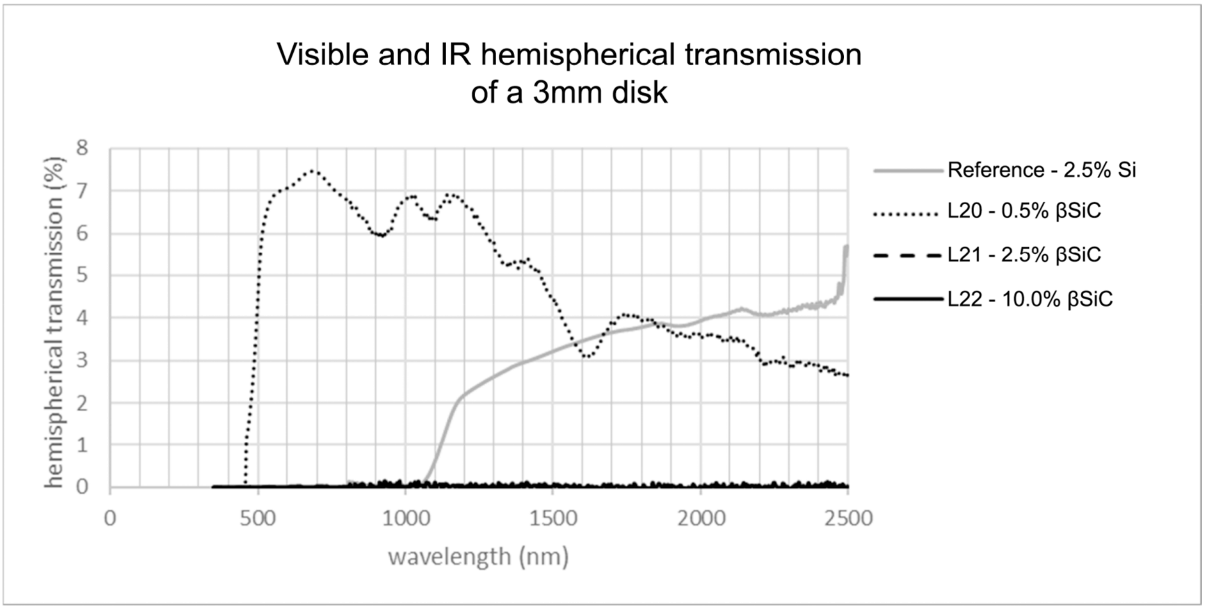

Figure 5

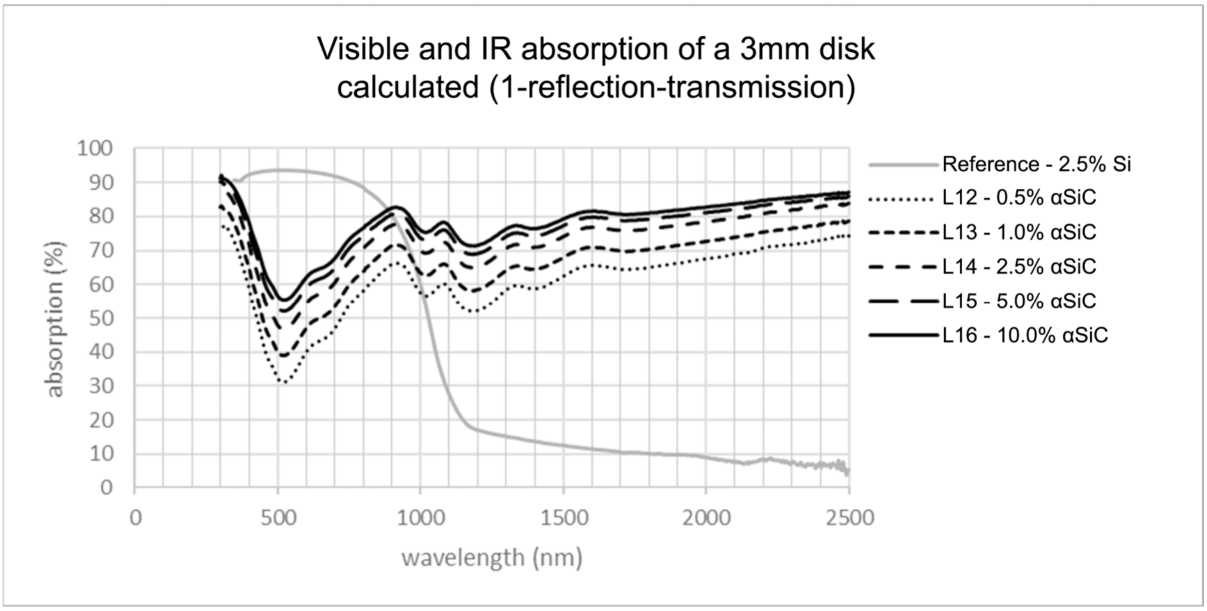


Figure 6

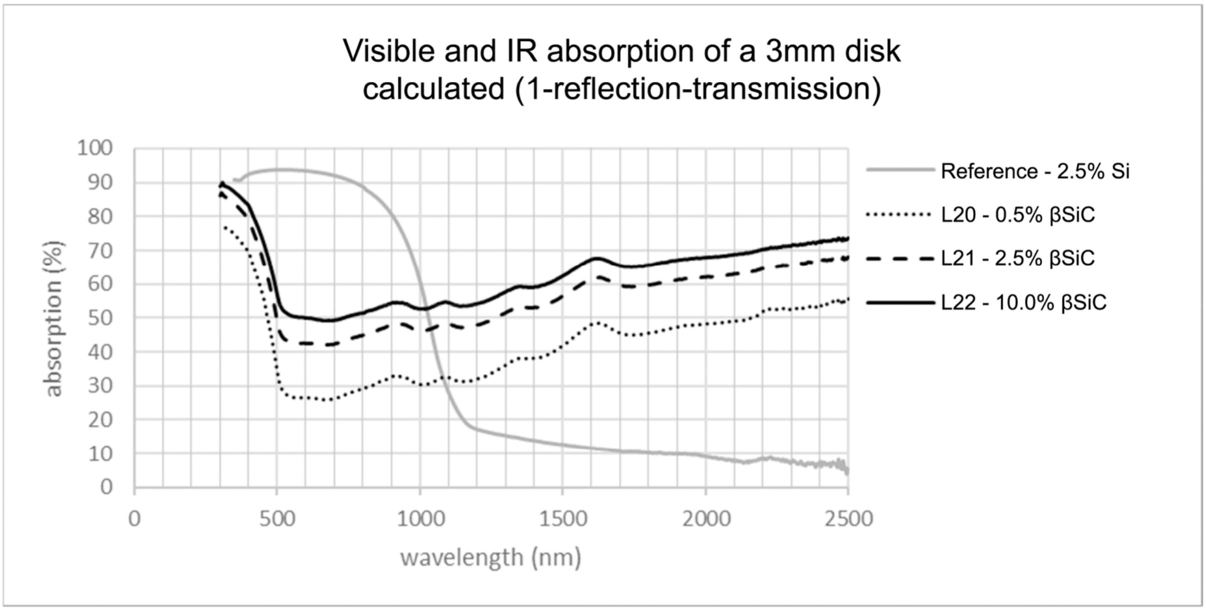

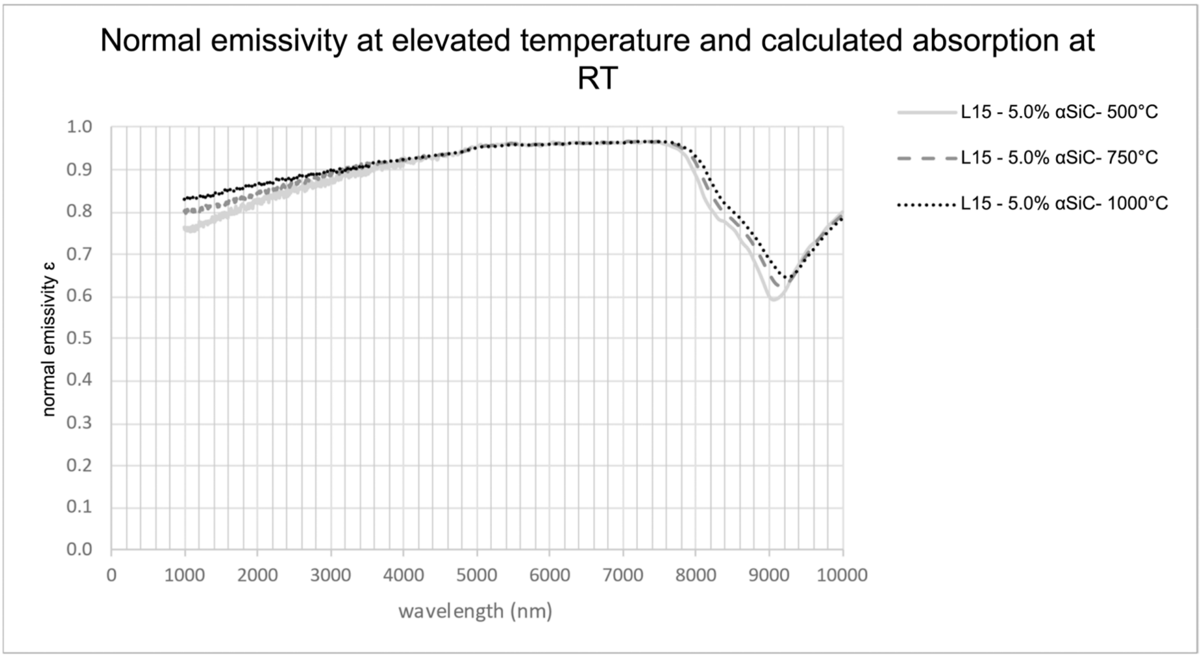
Normal emissivity at elevated temperature and calculated absorption at RT
L15 - 5.0% αSiC- 500°C
L15 - 5.0% αSiC- 750°C
L15 - 5.0% αSiC- 1000°C
normal emissivity ε
1.0
0.9
0.8
0.7
0.6
0.5
0.4
0.3
0.2
0.1
0.0
0
1000
2000
3000
4000
5000
6000
7000
8000
9000
10000
wavelength (nm)

Figure 8

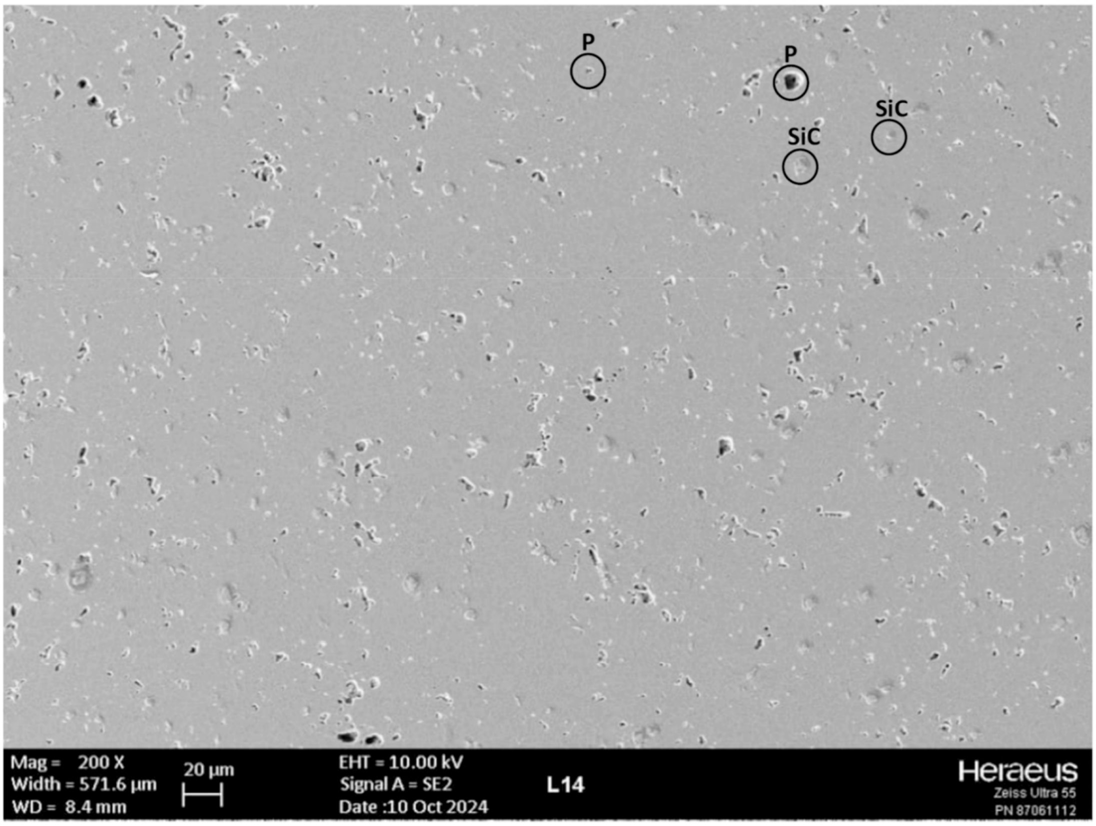
P
P
SiC
SiC
Mag = 200 X
Width = 571.6 µm
WD = 8.4 mm
20 µm
EHT = 10.00 kV
Signal A = SE2
Date :10 Oct 2024
L14
Heraeus
Zeiss Ultra 55
PN 87061112

Figure 9

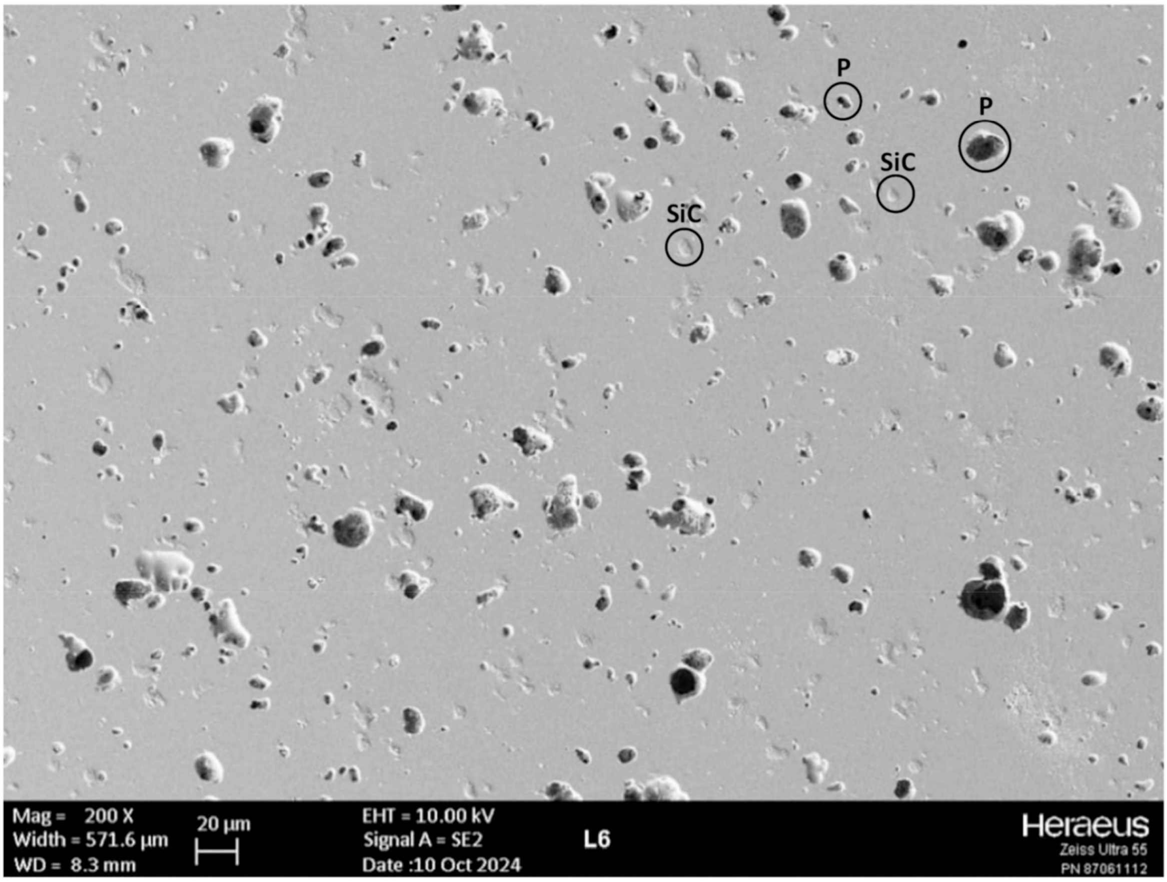


Figure 10

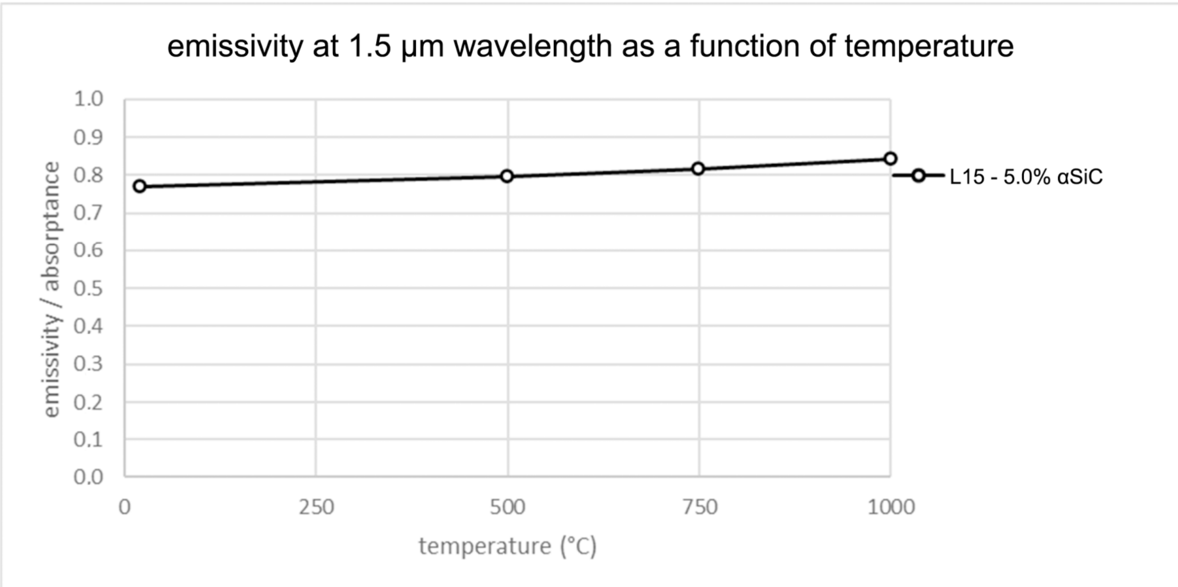

Europäisches Patentamt
European Patent Office
Office européen des brevets

# EUROPEAN SEARCH REPORT

Application Number
EP 25 21 0324

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 355 587 B1 (LOXLEY TED A [US] ET AL) 12 March 2002 (2002-03-12)<br>* column 31, lines 44-50; claims; examples *<br>----- | 1-15 | INV.<br>C03C14/00<br>C03B19/06 |
| X | JP H05 170477 A (TOSOH CORP; NIPPON SEKIEI GLASS KK) 9 July 1993 (1993-07-09)<br>* the whole document *<br>----- | 1-10,<br>12-15 | |
| X | US 2001/025001 A1 (ODA TOSHIO [JP] ET AL) 27 September 2001 (2001-09-27)<br>* paragraphs [0035] - [0043]; claims; examples *<br>----- | 1-11,15 | |
| X | JP H06 122533 A (TOSOH CORP) 6 May 1994 (1994-05-06)<br>* the whole document *<br>----- | 1-11,15 | |

TECHNICAL FIELDS SEARCHED (IPC)

C03C
C03B

The present search report has been drawn up for all claims

1

| Place of search | Date of completion of the search | Examiner |
|---|---|---|
| Munich | 26 January 2026 | Wrba, Jürgen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 21 0324

This annex lists the patent family members relating to the patent documents cited in the above-mentioned European search report. The members are as contained in the European Patent Office EDP file on
The European Patent Office is in no way liable for these particulars which are merely given for the purpose of information.

26-01-2026

| Patent document cited in search report | Publication date | Patent family member(s) | Publication date |
|---|---|---|---|
| US 6355587 B1 | 12-03-2002 | NONE | |
| JP H05170477 A | 09-07-1993 | JP 3112111 B2 | 27-11-2000 |
| | | JP H05170477 A | 09-07-1993 |
| US 2001025001 A1 | 27-09-2001 | NONE | |
| JP H06122533 A | 06-05-1994 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 3068739 A
- US 2001025001 A
- JP 2006027930 A
- JP H05170477 A
- US 5674792 A
- US 6355587 B
- JP H06122533 B
- WO 2025159866 A
- US 20250236987 A

### Non-patent literature cited in the description

- **J. MANARA** ; **M. KELLER** ; **D. KRAUS** ; **M. ARDUINI-SCHUSTER**. DETERMINING THE TRANSMITTANCE AND EMITTANCE OF TRANSPARENT AND SEMITRANSPARENT MATERIALS AT ELEVATED TEMPERATURES. *5th European Thermal-Sciences Conference, Netherlands*, 2008